# EUROPEAN PATENT SPECIFICATION

(11) **EP 3 352 538 B1**
(45) Date of publication and mention of the grant of the patent: **08.12.2021**
(21) Application number: 18151442.3
(22) Date of filing: 12.01.2018
(51) Int. Cl.: H05K 5/00

(54) **ASSEMBLY STRUCTURE**
MONTAGESTRUKTUR
STRUCTURE D'ASSEMBLAGE

(30) Priority: 19.01.2017 JP 2017007909
(43) Date of publication of application: 25.07.2018
(73) Proprietor: Alpine Electronics, Inc., Tokyo (JP)
(72) Inventor: Yamamoto, Kenta, Iwaki-city, Fukushima (JP); Kida, Shinobu, Iwaki-city, Fukushima (JP)
(74) Representative: Schmitt-Nilson Schraud Waibel Wohlfrom Patentanwälte Partnerschaft mbB

(56) References cited:
- WO-A1-2007/046789
- TW-U- M 530 509
- US-A1- 2015 061 475

## Description

The present invention relates to an assembly structure.

A housing or the like of an electronic device includes a plurality of external components, and the external components are generally assembled together by a fixing method other than screw fastening. Specifically, assembling is performed by combining a fixing method using hook fixation, a fixing method using fitting fixation, and the like.

In the fixing method using the hook fixation, for example, when one external component is assembled to the other external component, the external components are fixed to each other in an assembling direction. Further, in the fixing method using the fitting fixation, for example, the external components are fixed to each other in a direction (a direction substantially orthogonal to the assembling direction) that is different from the assembling direction.

WO 2007/046789 A1 discloses packages for peripheral devices such as memory media and input/output (I/O) devices. Its package contains a top cover and a bottom cover secured to each other through a locking mechanism. Its top cover contains one or more hooks on its lateral sides and a male latch at one end. Its bottom cover contains one or more recesses corresponding to the hooks and a female latch at one end corresponding to the male latch. When assembled, the hooks engage the recesses to secure the package in the X- and Z-axis; and the male latch engages the female latch to secure the package in the Y-axis.

TW M 530 509 U and E P 3 253 187 A1 disclose an electronic device housing, which may include a front cover and a back cover. Its front cover may include at least two flexible hooks and at least one fixation hook, and each of the flexible hook may include a hook body and a flexible member; one end of the flexible member may be connected to the front cover and the other end of the flexible member may provide support force to one side of the hook body. Its back cover may include at least two first fasteners, at least one fastener and at least three holes; the holes may be corresponding to the first fasteners and the second fastener; the first fasteners may be corresponding to the flexible hooks and engaged with the flexible hooks; the second fastener may be corresponding to the fixation hook and engaged with the fixation hook, whereby the front cover can be combined with the back cover.

US 2015/0061475 A1 discloses a deflection or snap fit type latch system can resist separation in at least three axes. Its snap fit type latch system can include a first member and a second member that when engaged are configured to form a snap fit connection, at least one of the members comprising a deflecting arm. A tee feature on the first member can include a stem and a head. A slot on the second member can slidingly receive the stem of the tee feature as the first and second members engage such that the second member is sandwiched between the first member and the head of the tee feature. Its snap fit connection can resist separation in a first axis and the combined tee feature and slot resist separation in two additional axes. Its snap fit type latch system can be part of an enclosure, such as a storage device.

### Citation List

### Patent Literature

Patent Literature 1: JP 2001-339174 A
Patent Literature 2: WO 2007/046789 A1
Patent Literature 3: TW M 530 509 U
Patent Literature 3a: EP 3 253 187 A1
Patent Literature 4: US 2015/0061475 A1

However, in the case of the combination of the fixing methods as described above, a strong fixing force can be achieved in the assembling direction, but it is not possible to achieve a sufficient fixing force in the direction different from the assembling direction. This is because, in the case of assembling the external components with each other, convex portions and concave portions to be fitted and fixed are configured to provide a certain degree of a gap for the intersection absorption.

As a result, when an external force is applied in the direction different from the assembling direction, there arises a problem that the external components slide with each other and a squeaking sound is generated at a position (for example, a hook fixing position) where the external components abut against each other.

In contrast, if the convex portions and the concave portions to be fitted and fixed are configured so as not to form a gap, sliding between the external components can be avoided and the occurrence of squeaking sound can be suppressed. However, there is a problem that it is not possible to absorb the intersection between the external components at the time of assembling, and the assembling work becomes difficult.

The present invention has been made in view of the above problems, and an object thereof is to provide an assembly structure that facilitates an assembling work and can suppress occurrence of a squeaking sound even when an external force is applied after assembling.

The invention relates to an assembly structure according to the appended claims.

It is possible to provide an assembly structure that facilitates the assembling work and can suppress occurrence of a squeaking sound even when an external force is applied after assembling.

### Brief Description of Drawings

FIGS. 1A and 1B are diagrams illustrating an external configuration of a display device.
FIG. 2 is a diagram illustrating an assembling direction in an assembling work of assembling a rear panel to a front panel.
FIG. 3 is a diagram illustrating an arrangement of abutting portions.
FIGS. 4A and 4B are diagrams illustrating a part of a combination of a first abutting portion and a second abutting portion disposed at a corner part of a display device.
FIGS. 5A and 5B are diagrams illustrating a combination of the first abutting portion and the second abutting portion disposed at a long side part of the display device.
FIGS. 6A and 6B are diagrams illustrating a part of a combination of the first abutting portion and the second abutting portion disposed at a short side part of the display device.
FIGS. 7A to 7C are diagram schematically illustrating a state at the time of assembling the first abutting portion and the second abutting portion.
FIGS. 8A to 8C are diagrams schematically illustrating another example of the second abutting portion.
FIGS. 9A and 9B are diagrams schematically illustrating another example of the first abutting portion.

Hereinafter, embodiments will be described with reference to the attached drawings. In the present specification and the drawings, constituent elements having substantially the same functional configuration are denoted by the same reference numerals, and the repeated description thereof will not be provided.

### [First Embodiment]

### <External Configuration of Electronic device>

First, a display device, which is an example of an electronic device having an assembly structure according to the first embodiment as an external component, will be described. Further, the display device referred to here includes, for example, a liquid crystal display device, a plasma display device, an organic electroluminescence (EL) display device and the like.

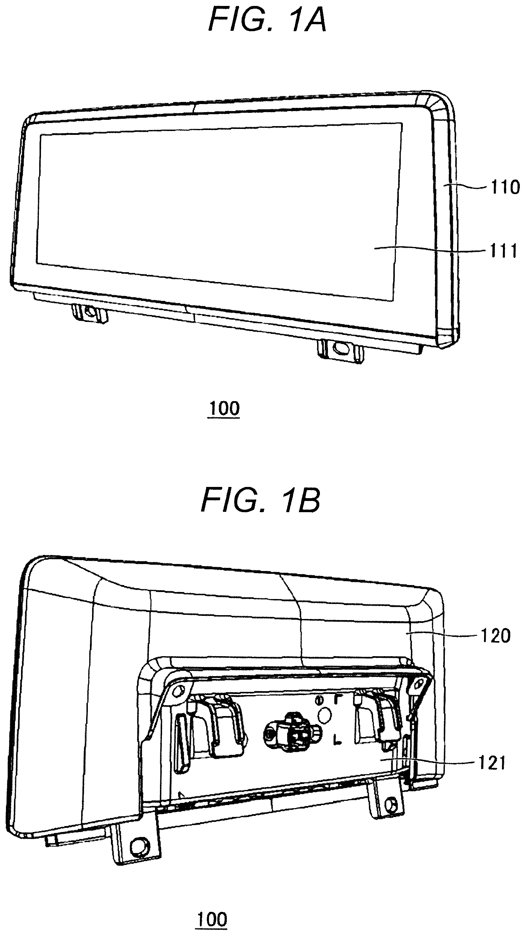

FIGS. 1A and 1B are diagrams illustrating an external configuration of a display device. FIG. 1A is a front perspective view of the display device 100, and FIG. 1B is a rear perspective view of the display device 100.

As illustrated in FIG. 1A, the display device 100 has a front panel 110 as an external component which is an assembly structure according to the first embodiment. Further, as illustrated in FIG. 1B, the display device 100 has a rear panel 120 as an external component which is the assembly structure according to the first embodiment.

An assembling process of the display device 100 includes an assembling work of assembling the rear panel 120 to the front panel 110 to which a display module 111, a holder 121, and the like are attached.

### <Description of Assembling Direction in Assembling Work>

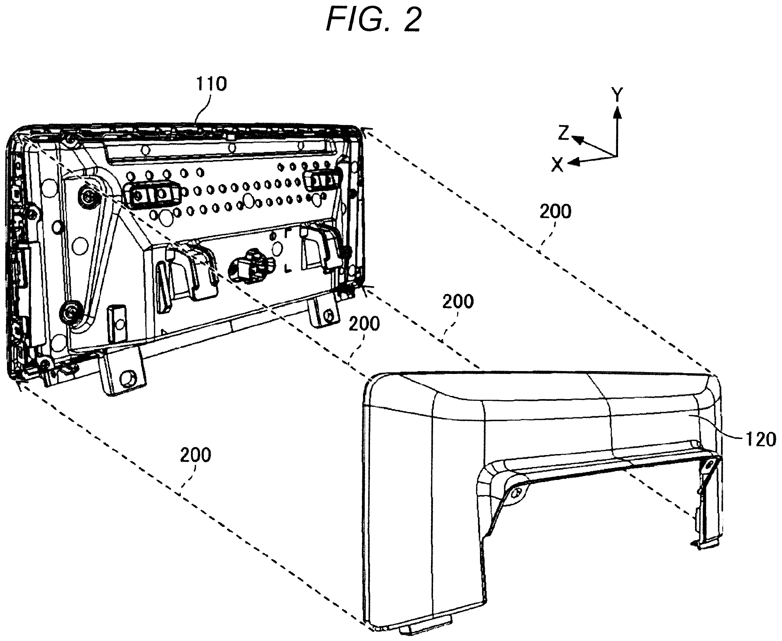

Next, the assembling direction in the assembling work of assembling the rear panel 120 to the front panel 110 will be described. FIG. 2 is a diagram illustrating the assembling direction in the assembling work of assembling the rear panel to the front panel.

As illustrated in FIG. 2, in the assembling work, by moving the rear panel 120 along an arrow 200, the rear panel 120 is assembled to the front panel 110. That is, in the example of FIG. 2, the rear panel 120 is an assembling component, and the front panel 110 is an assembled component. The arrow 200 is a direction substantially orthogonal to the surface of the display module 111 (not illustrated in FIG. 2) attached to the front panel 110, and in the first embodiment, this direction is referred to as an "assembling direction". Further, in the first embodiment, the assembling direction is defined as a Z-axis direction.

Further, in the direction substantially parallel to the surface of the display module 111, a direction substantially parallel to the long side direction of the display module 111 is defined as an X-axis direction, and a direction substantially parallel to the short side direction of the display module is defined as a Y-axis direction. Both the X-axis direction and the Y-axis direction are directions substantially orthogonal to the assembling direction.

### <Arrangement of Abutting Portion>

Next, the arrangement of the "abutting portions" which abut against each other by assembling the rear panel 120 to the front panel 110 to restrict the movement between the front panel 110 and the rear panel 120 will be described.

In the first embodiment, the abutting portions of the front panel 110 and the rear panel 120 can be broadly divided into two types.

The first abutting portion is an abutting portion that restricts the movement in the Z-axis direction between the rear panel 120 and the front panel 110 in a state in which the rear panel 120 is assembled to the front panel 110.

The second abutting portion is an abutting portion which restricts one of the movement in the X-axis direction, the movement in the Y-axis direction or both movements in the X-axis direction and the Y-axis direction between the rear panel 120 and the front panel 110, in the state in which the rear panel 120 is assembled to the front panel 110.

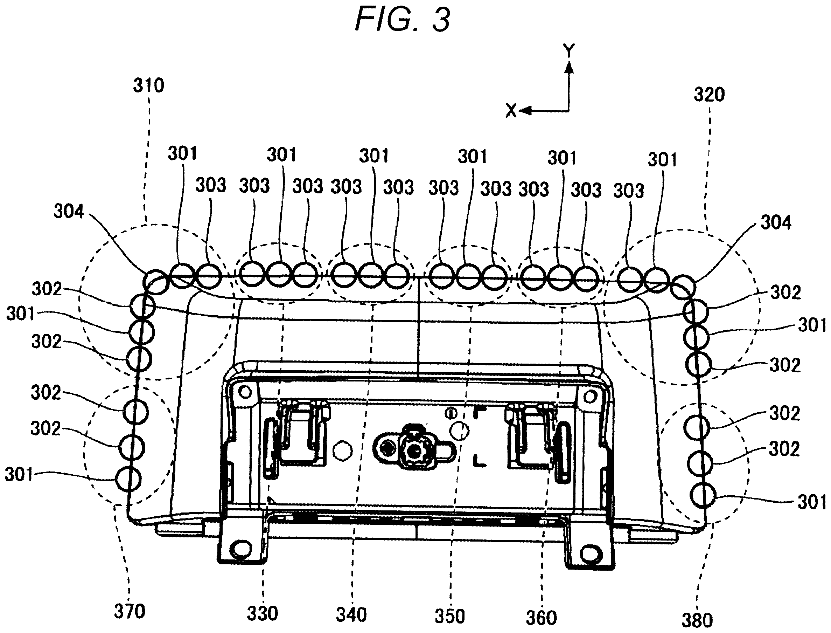

FIG. 3 is a diagram illustrating the arrangement of the abutting portions. In FIG. 3, circles 301 illustrate the positions at which the first abutting portion for restricting the movement in the Z-axis direction is disposed. In addition, circles 302 illustrate the positions at which the second abutting portion for restricting the movement in the X-axis direction is disposed. Circles 303 illustrate the positions at which the second abutting portion for restricting the movement in the Y-axis direction is disposed. Further, circles 304 illustrate the position at which the second abutting portion for restricting the movement in both the X-axis direction and the Y-axis direction is disposed.

As indicated by dotted lines 310 to 380 in FIG. 3, in each part (corner parts, long side parts, and short side parts) of the "outer circumferential surface" formed by assembling the rear panel 120 to the front panel 110, a plurality of combinations of the first abutting portion and the second abutting portion are disposed. Specifically, combinations indicated by dotted lines 310 and 320 are disposed at the corner parts, combinations indicated by dotted lines 330 to 360 are disposed at the long side parts, and combinations indicated by dotted lines 370 and 380 are disposed at the short side parts.

In this way, it is possible to suppress sliding between the rear panel 120 and the front panel 110, by disposing the combinations of the first abutting portion and the second abutting portion in each part.

### <Detailed Configuration of First Abutting Portion and Second Abutting portion Part 1 >

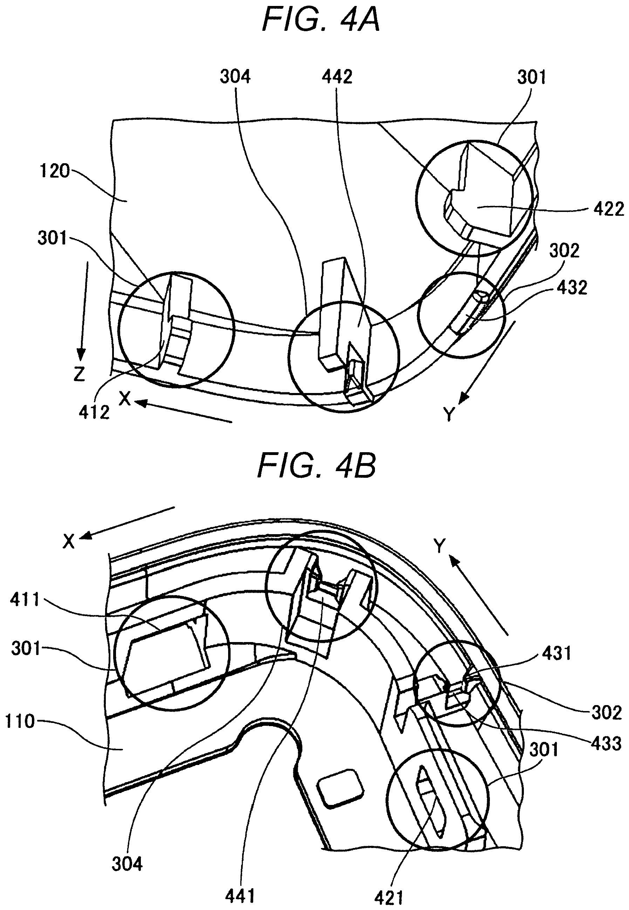

Next, detailed configurations of the first abutting portion and the second abutting portion will be described. FIGS. 4A and 4B are diagrams illustrating a part of a combination (dotted line 320 in FIG. 3) of the first abutting portion and the second abutting portion disposed at the corner part of the display device.

Among them, FIG. 4A illustrates an aspect in which the corner part of the rear panel 120 of the display device 100 is viewed from the interior, and FIG. 4B illustrates an aspect in which the corner part of the front panel 110 of the display device 100 is viewed from the interior.

As illustrated in FIG. 4A, hook members 412 and 422 extending in the Z-axis direction are disposed as first abutting portions at the position indicated by the circle 301 of the rear panel 120. As illustrated in FIG. 4B, hook receiving members 411 and 421, which are examples of locking members, are disposed as the first abutting portions at the position indicated by the circle 301 of the front panel 110.

When the hook member 412 or the like is locked to the hook receiving member 411 or the like in the state of assembling the rear panel 120 to the front panel 110, the hook receiving member 411 or the like can restrict the movement in a direction opposite to the assembling direction of the hook member 412 or the like. As a result, according to the first abutting portion indicated by the circle 301, it is possible to avoid the rear panel 120 from sliding in the direction opposite to the assembling direction with respect to the front panel 110.

Further, as illustrated in FIG. 4A, at the position indicated by a circle 302 of the rear panel 120, as a second abutting portion for restricting the movement in the X-axis direction, a protruding member 432 extending in the Z-axis direction is disposed. The protruding member 432, and the abutting portion 433 on the front panel 110 side against which the protruding member 432 butts form a part of the locking member which locks the hook member 412 or the like so as not to move in the assembling direction in a state in which the rear panel 120 is assembled to the front panel 110. Further, as illustrated in FIG. 4B, at the position indicated by the circle 302 of the front panel 110, as a second abutting portion for restricting the movement in the X-axis direction, a rigid fitting member 431 having a strong fitting shape is disposed.

When the rear panel 120 is assembled to the front panel 110, since a part (the protrusion in the X-axis direction) of the rigid fitting member 431 is plastically deformed by the protruding member 432, the rigid fitting member 431 rigidly fits the protruding member 432. Accordingly, the rigid fitting member 431 can restrict the movement of the protruding member 432 in the X-axis direction. As a result, according to the second abutting portion indicated by the circle 302, it is possible to avoid the rear panel 120 from sliding in the X-axis direction with respect to the front panel 110.

Further, as illustrated in FIG. 4A, at a position (a position corresponding to the position at which the curved surface is formed, on the outer circumferential surface) indicated by a circle 304 of the rear panel 120, as a second abutting portion for restricting movement in the X-axis direction and the Y-axis direction, a protruding member 442 extending in the Z-axis direction is disposed. Further, as illustrated in FIG. 4B, at the position indicated by the circle 304 of the front panel 110, as a second abutting portion for restricting the movement in the X-axis direction and the Y-axis direction, a rigid fitting member 441 is disposed.

When the rear panel 120 is assembled to the front panel 110, since a part of the rigid fitting member 441 is plastically deformed by the protruding member 442, the rigid fitting member 441 rigidly fits the protruding member 442. At this time, the plastically deformed part is a protrusion extending in a direction of approximately 45 degrees with respect to the X-axis direction and approximately 45 degrees with respect to the Y-axis direction. Therefore, the rigid fitting member 441 can restrict the movement of the protruding member 442 in the X-axis direction and the Y-axis direction. As a result, according to the second abutting portion indicated by a circle 304, it is possible to avoid the rear panel 120 from sliding in the X-axis direction and sliding in the Y-axis direction with respect to the front panel 110.

In this way, by providing a configuration that avoids the first abutting portion and the second abutting portion from sliding in the Z-axis direction, the X-axis direction and the Y-axis direction, respectively, it is possible to suppress an occurrence of squeaking sound.

In addition, by disposing the second abutting portion in the vicinity of the first abutting portion, it is possible to suppress the occurrence of squeaking sound caused by sliding at the first abutting portion in the X-axis direction or the Y-axis direction.

### <Detailed Configuration of First Abutting portion and Second Abutting portion Part 2>

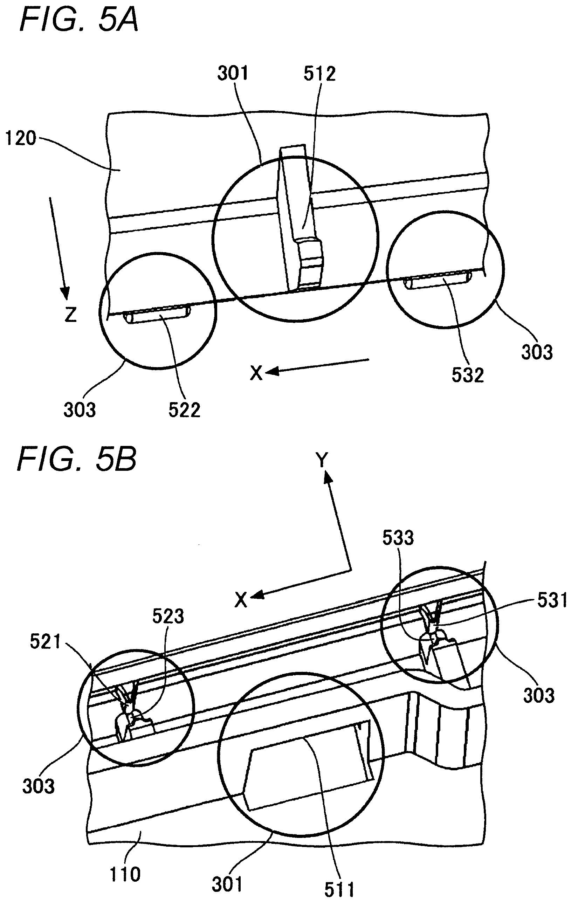

FIGS. 5A and 5B are diagrams illustrating a combination (dotted line 350 in FIG. 3) of the first abutting portion and the second abutting portion disposed at the long side part of the display device.

FIG. 5A illustrates an aspect in which the long side part of the rear panel 120 of the display device 100 is viewed from the interior, and FIG. 5B illustrates an aspect in which the long side part of the front panel 110 of the display device 100 is viewed from the interior.

As illustrated in FIG. 5A, at a position (a position corresponding to a position at which a flat surface is formed, on the outer circumferential surface) indicated by a circle 301 of the rear panel 120, as the first abutting portion, a hook member 512 extending in the Z-axis direction is disposed. Further, as illustrated in FIG. 5B, a hook receiving member 511 is disposed as the first abutting portion at a position indicated by a circle 301 of the front panel 110.

When the hook member 512 is locked to the hook receiving member 511 in a state in which the rear panel 120 is assembled to the front panel 110, the hook receiving member 511 restricts the movement in the direction opposite to the assembling direction of the hook member 512. As a result, according to the first abutting portion indicated by the circle 301, it is possible to avoid the rear panel 120 from sliding with respect to the front panel 110 in the direction opposite to the assembling direction.

Further, as illustrated in FIG. 5A, at a position (a position corresponding to a position at which a flat surface is formed, on the outer circumferential surface) indicated by a circle 303 of the rear panel 120, as the second abutting portion for restricting the movement in the Y-axis direction, protruding members 522 and 532 extending in the Z-axis direction are disposed. Further, the protruding members 522 and 532, and the abutting portions 523 and 533 on the front panel 110 side against which the protruding members 522 and 532 butt form a part of a locking member which locks the hook member 512 so as not to move in the assembling direction, in a state in which the rear panel 120 is assembled to the front panel 110. Further, as illustrated in FIG. 5B, strong engagement members 521 and 531 are disposed as second abutting portions for estricting movement in the Y-axis direction at the position indicated by the circle 303 of the front panel 110.

When the rear panel 120 is assembled to the front panel 110, some parts (protrusions disposed in the Y-axis direction substantially orthogonal to the flat surface) of the rigid fitting members 521 and 531 are plastically deformed by the protruding members 522 and 532. Therefore, the rigid fitting members 521 and 531 can rigidly fit the protruding members 522 and 532 to restrict the movement of the protruding members 522 and 532 in the Y-axis direction. As a result, according to the second abutting portion indicated by the circle 303, it is possible to avoid the rear panel 120 from sliding with respect to the front panel 110 in the Y-axis direction.

In this way, by providing a configuration in which the first abutting portion and the second abutting portion do not slide in the Z-axis direction and the Y-axis direction, respectively, it is possible to suppress the occurrence of squeaking sound.

In addition, by disposing the first abutting portion so as to be interposed by the second abutting portions, it is possible to further suppress the occurrence of squeaking sound caused by sliding at the first abutting portion in the Y-axis direction.

### <Detailed Configuration of First Abutting Portion and Second Abutting Portion Part 3>

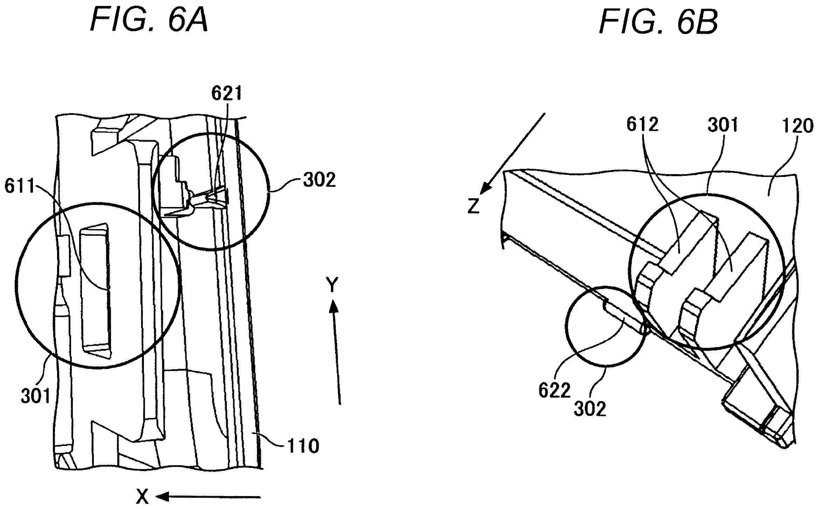

FIGS. 6A and 6B are diagrams illustrating a part of a combination (dotted line 380 in FIG. 3) of the first abutting portion and the second abutting portion disposed at the short side part of the display device.

FIG. 6A illustrates an aspect in which the short side part of the front panel 110 of the display device 100 is viewed from the interior, and FIG. 6B illustrates an aspect in which the short side part of the rear panel 120 of the display device 100 is viewed from the interior.

As illustrated in FIG. 6A, at a position (a position corresponding to a position at which a flat surface is formed on the outer circumferential surface) indicated by a circle 301 of the front panel 110, a hook receiving member 611 is disposed as a first abutting portion. As illustrated in FIG. 6B, at a position indicated by the circle 301 of the rear panel 120, two hook members 612 extending in the Z-axis direction are disposed as the first abutting portions.

When the hook member 612 is locked to the hook receiving member 611 in the state of assembling the rear panel 120 to the front panel 110, the hook receiving member 611 can restrict the movement in the direction opposite to the assembling direction of the hook member 612. As a result, according to the first abutting portion indicated by the circle 301, it is possible to avoid the rear panel 120 from sliding with respect to the front panel 110 in the direction opposite to the assembling direction.

Further, as illustrated in FIG. 6A, at a position (a position corresponding to a position at which a flat surface is formed, on the outer circumferential surface) indicated by a circle 302 of the front panel 110, a rigid fitting member 621 is disposed as a second abutting portion which restricts the movement in the X-axis direction. Further, as illustrated in FIG. 6B, at a position indicated by a circle 302 of the rear panel 120, a protruding member 622 extending in the Z-axis direction is disposed as a second abutting portion which restricts the movement in the X-axis direction.

When assembling the rear panel 120 to the front panel 110, a part (a protrusion disposed to face the X-axis direction substantially orthogonal to the flat surface) of the rigid fitting member 621 is plastically deformed by the protruding member 622. Therefore, the rigid fitting member 621 rigidly fits the protruding member 622 and can restrict the movement of the protruding member 622 in the X-axis direction. As a result, according to the second abutting portion indicated by a circle 302, it is possible to avoid the rear panel 120 from sliding with respect to the front panel 110 in the X-axis direction.

In this way, by providing a configuration in which the first abutting portion and the second abutting portion do not slide in the Z-axis direction and the X-axis direction, respectively, it is possible to suppress the occurrence of squeaking sound.

In addition, by disposing the second abutting portion in the vicinity of the first abutting portion, it is possible to further suppress the occurrence of squeaking sound caused by sliding in the X-axis direction at the first abutting portion.

### <Functions of First Abutting portion and Second Abutting portion at the time of Assembling>

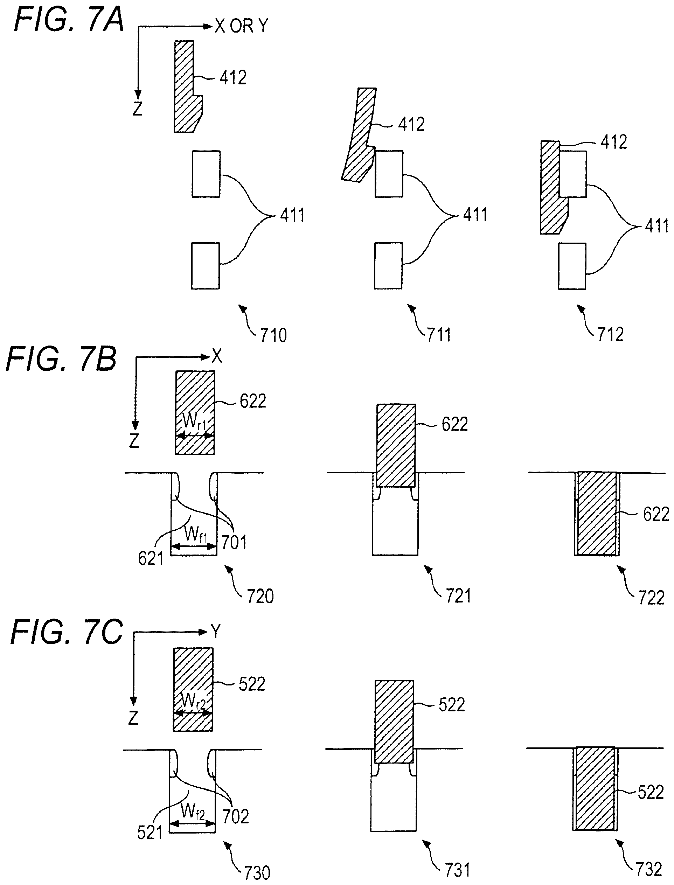

Next, functions of the first abutting portion and the second abutting portion at the time of assembling will be described. FIGS. 7A to 7C are diagrams schematically illustrating an aspect at the time of assembling the first abutting portion and the second abutting portion.

Among them, FIG. 7A is a diagram schematically illustrating an aspect at the time of assembling the first abutting portion. By moving the rear panel 120 in the assembling direction, the hook member 412 moves in the Z-axis direction (see reference numeral 710) as illustrated in FIG. 7A. The hook member 412 moves in the Z-axis direction while being elastically deformed when abutting against the hook receiving member 411 (see reference numeral 711). When the hook member 412 reaches the opening portion of the hook receiving member 411, the hook member 412 is locked to the hook receiving member 411 (see reference numeral 712). In this way, in the hook member 412, the intersection between the front panel 110 and the rear panel 120 is absorbed by being elastically deformed at the time of assembling.

FIG. 7B is a diagram schematically illustrating an aspect at the time of assembling the second abutting portion which restricts the movement in the X-axis direction. By moving the rear panel 120 in the assembling direction, the protruding member 622 moves in the Z-axis direction (see reference numeral 720) as illustrated in FIG. 7B. When the protruding member 622 abuts against a part (the protrusion 701 in the X-axis direction) of the rigid fitting member 621, the protruding member 622 moves in the Z-axis direction while plastically deforming the protrusion 701 in the X-axis direction of the rigid fitting member 621 (see reference numeral 721) to reach the abutting portion of the rigid fitting member 621 (see reference numeral 722).

Here, as illustrated in FIG. 7B, a length W_{f1} of the rigid fitting member 621 in the X-axis direction is longer than a length Wᵣ₁ of the protruding member 622 in the X-axis direction. Therefore, the intersection between the front panel 110 and the rear panel 120 can be absorbed by a difference between the length W_{f1} and the length Wᵣ₁. As a result, according to the second abutting portion which restricts the movement in the X-axis direction, it is possible to avoid a situation in which the assembling work becomes difficult.

Further, in the example of FIG. 7B, the protrusion 701 in the X-axis direction has a shape disposed in a part of the rigid fitting member 621 in the Z-axis direction, as a strong fitting shape. However, the protrusion 701 in the X-axis direction may have a shape disposed in the entire Z-axis direction of the rigid fitting member 621.

FIG. 7C is a diagram schematically illustrating the aspect at the time of assembling the second abutting portion for restricting the movement in the Y-axis direction. By moving the rear panel 120 in the assembling direction, as illustrated in FIG. 7C, the protruding member 522 moves in the Z-axis direction (see reference numeral 730). When the protruding member 522 abuts against a part (the protrusion 702 in the Y-axis direction) of the rigid fitting member 521, the protruding member 522 moves in the Z-axis direction, while plastically deforming the protrusion 702 of the rigid fitting member 521 in the Y-axis direction (see reference numeral 731) to reach the abutting portion of the rigid fitting member 521 (see reference numeral 732).

Here, as illustrated in FIG. 7C, a length W_{f2} of the rigid fitting member 621 in the Y-axis direction is longer than a length Wᵣ₂ of the protruding member 522 in the Y-axis direction. Therefore, the intersection between the front panel 110 and the rear panel 120 can be absorbed by the difference between the length W_{f2} and the length Wᵣ₂. As a result, according to the second abutting portion that restricts the movement in the Y-axis direction, it is possible to avoid a situation in which the assembling work becomes difficult.

In the example of FIG. 7C, the protrusion 702 in the Y-axis direction has a shape disposed in a part of the rigid fitting member 521 in the Z-axis direction as a strong fitting shape, but the protrusion 702 in the Y-axis direction may have a shape disposed in the entire Z-axis direction of the rigid fitting member 521.

Further, the hook member 412 of FIG. 7A is configured to be locked to the hook receiving member 411, in a state in which each of the protruding members 622 and 522 of FIGS. 7B and 7C reaches the abutting portions of the rigid fitting members 621 and 521. That is, the movement of the hook member 412 in the assembling direction of the first abutting portion is restricted by the second abutting portion (abutting portions of the rigid fitting members 621 and 521). As a result, according to the second abutting portion, it is possible to avoid the rear panel 120 from sliding in the assembling direction with respect to the front panel 110.

### <Summary>

As is apparent from the above description, in the first embodiment, in the assembly structure of the front panel 110 and the rear panel 120, as the first abutting portion,
an elastically deformable hook member extending in the assembling direction (Z-axis direction) is disposed in the rear panel 120,
a hook receiving member to be hooked by the hook member is disposed on the front panel 110,
by locking the hook member to the hook receiving member in the state of assembling the rear panel 120 to the front panel 110, movement in the direction opposite to the assembling direction is restricted, and
a protruding member extending in the assembling direction (Z-axis direction) is disposed in the rear panel 120, the abutting portion is provided on the front panel 110, when the protruding member butts against the abutting portion, the movement in the assembling direction is restricted, and the hook member does not move along the assembling direction.

Further, in the assembly structure, as the second abutting portion,
a protruding member extending in the assembling direction (Z-axis direction) is disposed on the rear panel 120,
a rigid fitting member which rigidly fits the protruding member is disposed on the front panel 110,
in a state in which the rear panel 120 is assembled to the front panel 110, the rigid fitting member rigidly fits the protruding member to restrict the movement of the protruding member in the X-axis direction or the Y-axis direction or both substantially orthogonal to the assembling direction.

As a result, even when an external force is applied in the X-axis direction, the Y-axis direction or the Z-axis direction after assembling, it is possible to avoid a situation in which the rear panel 120 slides with respect to the front panel 110 and suppress the occurrence of squeaking sound.

Further, according to the above configuration, since the intersection between the front panel 110 and rear panel 120 can be absorbed by the elastically deformed protrusion and the plastically deformed hook member, it is possible to avoid the situation in which the assembling work becomes difficult.

That is, according to the first embodiment, it is possible to provide an assembly structure that can facilitate the assembling work and can suppress the occurrence of squeaking sounds even when an external force is applied after assembling.

### [Second Embodiment]

In the first embodiment, as the second abutting portion, the rigid fitting member having the protrusion in a predetermined axial direction (for example, the rigid fitting member 621 having the protrusion 701 in the X-axis direction, and the rigid fitting member 521 having the protrusion 702 in the Y-axis direction) is disposed. However, the shape of the rigid fitting member in the second abutting portion is not limited thereto. For example, a shape having a plurality of protrusions in different axial directions may be used.

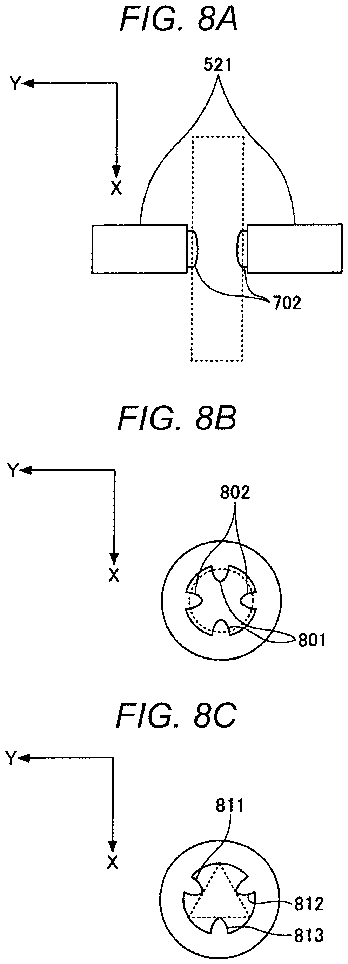

FIGS. 8A to 8C are diagrams schematically illustrating another example of the second abutting portion, and are schematic views when the front panel 110 is viewed from the interior. In FIGS. 8A to 8C, a solid line illustrates the rigid fitting member disposed on the front panel 110 side as the second abutting portion, and a dotted line illustrates the protruding member disposed on the rear panel 120 side as the second abutting portion.

Among them, FIG. 8A schematically illustrates a relation between the protruding member 522 and the rigid fitting member 521 illustrated in the first embodiment for comparison. On the other hand, FIGS. 8B and 8C schematically illustrate a relation between the protruding member and the rigid fitting member in the second embodiment.

As illustrated in FIG. 8A, in the first embodiment, for example, a pair of protrusions 702 is provided at positions facing each other in the Y-axis direction to restrict the movement in the Y-axis direction. In contrast, as illustrated in FIG. 8B, in the second embodiment, a pair of protrusions 801 is disposed at positions facing each other in the X-axis direction, and a pair of protrusions 802 is provided at positions facing each other in the Y-axis direction. Furthermore, in the second embodiment, the protruding member is formed in a cylindrical shape and the rigid fitting member is formed in a cylindrical shape.

In this way, by disposing the protrusions at the positions facing each other in the X-axis direction and in the Y-axis direction, respectively, in the second embodiment, in the second abutting portion, it is possible to restrict the movement of the protruding member both in the X-axis direction and the Y-axis direction.

Alternatively, as illustrated in FIG. 8C, in the second embodiment, the protrusions 811 to 813 are disposed at three positions, the protruding member is formed in a triangular prism shape, and the rigid fitting member is formed in a cylindrical shape.

In this way, by disposing the protrusions at three positions, in the second embodiment, at the second abutting portion, it is possible to restrict the movement of the protruding member in an arbitrary direction substantially orthogonal to the Z-axis direction.

As described above, according to the second embodiment, it is possible to restrict the movement in a plurality of directions substantially orthogonal to the Z-axis direction at one position of the second abutting portion.

### [Third Embodiment]

In the first embodiment, as the first abutting portion, a hook receiving member having a rectangular opening portion is disposed on the front panel 110 side. In contrast, in the third embodiment, a hook receiving member having a trapezoidal shaped opening portion is disposed as the first abutting portion on the front panel 110 side.

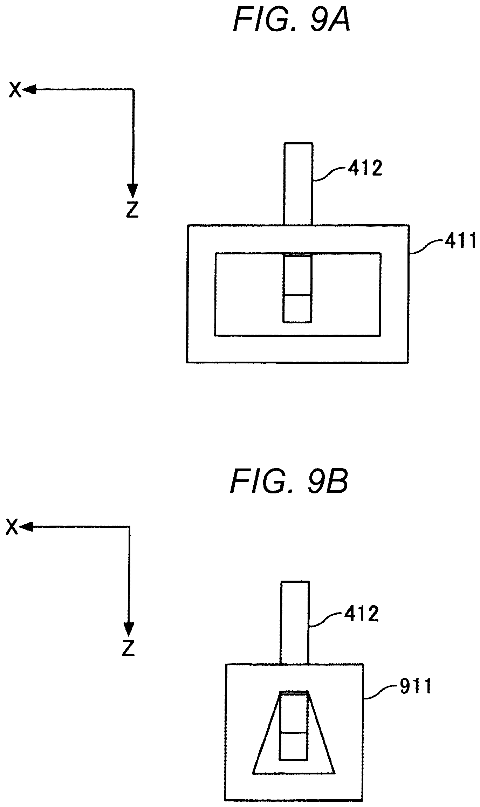

FIGS. 9A and 9B are diagrams schematically illustrating another example of the first abutting portion, and are schematic views when the state of locking the hook receiving member to the hook member is viewed from the interior of the front panel 110.

Among them, FIG. 9A schematically illustrates the hook member 412 and the hook receiving member 411 described in the first embodiment for comparison. On the other hand, FIG. 9B schematically illustrates the hook member 412 and the hook receiving member 911 in the third embodiment.

As illustrated in FIG. 9B, by forming the opening portion of the hook receiving member 911 into a trapezoidal shape, even when an external force is applied in the X-axis direction, the hook member 412 is hard to shift in the X-axis direction. That is, according to the third embodiment, it is possible to make it difficult for the first abutting portion to slide against an external force in a direction substantially orthogonal to the Z-axis direction.

### [Other Embodiments]

In the aforementioned first embodiment, the material of the protrusion of the rigid fitting member is not particularly mentioned, but the material of the protrusion may be the same as or different from the material of the front panel 110 (the shape may be a shape that is easily plastically deformed, and the material thereof is arbitrary).

In the first embodiment, in the first abutting portion, the hook member is disposed on the rear panel 120 side and the hook receiving member is disposed on the front panel 110 side. However, the hook member may be disposed on the front panel 110 side and the hook receiving member may be disposed on the rear panel 120 side.

Further, in the first embodiment, in the second abutting portion, the protruding member is disposed on the rear panel 120 side and the rigid fitting member is disposed on the front panel 110 side. However, a protruding member may be disposed on the front panel 110 side and a rigid fitting member may be disposed on the rear panel 120 side.

Further, in the first embodiment, the rear panel 120 is illustrated as being assembled to the front panel 110, but the assembling direction may be opposite. That is, the front panel 110 may be assembled to the rear panel 120.

Further, in the first embodiment, four sets (dotted lines 330 to 360 of FIG. 3) of combinations of the first abutting portion and the second abutting portion for restricting the movement in the Y-axis direction are illustrated as being disposed at the long side part of the display device 100. However, the number of combinations of the abutting portions disposed at the long side part is not limited thereto.

Further, in the first embodiment, the combination of the abutting portions disposed at the long side part of the display device 100 includes one first abutting portion and two second abutting portions, but the number and the arrangement of the abutting portions included in the combination of the abutting portions are not limited thereto. Further, the same also applies to the combination of the abutting portions disposed at the short side part and the corner part, and the number and the arrangement of the abutting portions included in the combination of the abutting portions illustrated in the first embodiment are only an example.

Further, in each of the above-described embodiments, the display device 100 has been described as an example of the external component of the electronic device to which the assembly structure is applied, but the invention may be applied to the external components of the electronic device other than the display device 100.

### Reference Signs List

100: display device
110: front panel
120: rear panel
301: circle (position of first abutting portion)
302: circle (position of second abutting portion that restricts movement in X-axis direction)
303: circle (position of second abutting portion that restricts movement in Y-axis direction)
304: circle (position of second abutting portion that restricts movement in X-axis direction and Y-axis direction)
411, 421: hook receiving member
412, 422: hook member
431, 441: rigid fitting member
432, 442: protruding member
433: abutting portion
511: hook receiving member
512: hook member
521, 531: rigid fitting member
522, 532: protruding member
611: hook receiving member
612: hook member
621: rigid fitting member
622: protruding member
523, 533: abutting portion
701, 702: protrusion
801: protrusion
811 to 813: protrusion

## Claims

1. An assembly structure having an assembling component (120) and an assembled component (110) assembled to the assembling component (120), the assembly structure comprising:
a first abutting portion (301) and a second abutting portion (302) in which the assembling component (120) and the assembled component (110) abut against each other when the assembled component (110) is assembled by the assembling component (120),
wherein the first abutting portion (301) has
(i) a hook member (422) extending in the assembling direction, and
(ii) a locking member (421) which locks the hook member (422) so as not to move along the assembling direction in a state in which the assembled component (110) is assembled to the assembling component (120), and
wherein the second abutting portion (302) has
(i) a protruding member (432) extending in the assembling direction, and
(ii) a rigid fitting member (431) which rigidly fits the protruding member (432) by the rigid fitting member (431) being plastically deformed by the protruding member (432) when the assembled component (110) is assembled to the assembling component (120), thereby restricting the movement of the protruding member (432) in a direction substantially orthogonal to the assembling direction,
**characterized in that**
a plurality of protrusions (701, 702, 801, 802), plastically deformed by the protruding member (432) are disposed on the rigid fitting member (431) in a plurality of directions substantially orthogonal to the assembling direction.

2. The assembly structure according to claim 1, **characterized in that** the second abutting portion (302) is disposed at a position corresponding to a position at which a curved surface is formed, on an outer circumferential surface formed by the assembled component (110) and the assembling component (120), in a state in which the assembled component (110) is assembled by the assembling component (120).

3. The assembly structure according to claim 1 or 2, **characterized in that** the first abutting portion (301) is disposed to be interposed between two second abutting portions (302,) at a position corresponding to a position, at which a flat surface is formed, on the outer circumferential surface.

4. The assembly structure according to claim 3, **characterized in that** protrusions (702) plastically deformed by protruding members (432) are disposed on rigid fitting members (431) of the second abutting portion (302) in a direction substantially orthogonal to the flat surface to face each other.

5. The assembly structure according to one of claims 1-3, **characterized in that**
the hook member (422) is disposed on the assembling component (120) and the locking member (421) is disposed on the assembled component (110) at the first abutting portion (301), and
the protruding member (432) is disposed on the assembling component (120) and the rigid fitting member (431) is disposed on the assembled component (110) at the second abutting portion (302).

## Patentansprüche

1. Montagestruktur mit einer Montagekomponente (120) und einer montierten Komponente (110), die an der Montagekomponente (120) montiert ist, wobei die Montagestruktur Folgendes aufweist:
einen ersten Anlagebereich (301) und einen zweiten Anlagebereich (302), in denen die Montagekomponente (120) und die montierte Komponente (110) aneinander anliegen, wenn die montierte Komponente (110) mittels der Montagekomponente (120) montiert ist,
wobei der erste Anlagebereich (301)
(i) ein Hakenelement (422), das sich in der Montagerichtung erstreckt, und
(ii) ein Verriegelungselement (421) aufweist, das das Hakenelement (422) derart verriegelt, dass sich dieses in einem Zustand, in dem die montierte Komponente (110) an der Montagekomponente (120) montiert ist, nicht entlang der Montagerichtung bewegt, und
wobei der zweite Anlagebereich (302)
(i) ein vorstehendes Element (432), das sich in der Montagerichtung erstreckt, und
(ii) ein starres Passelement (431) aufweist, das starr mit dem vorstehenden Element (432) zusammenpasst, indem es durch das vorstehende Element (432) plastisch verformt wird, wenn die montierte Komponente (110) an der Montagekomponente (120) montiert wird, wodurch die Bewegung des vorstehenden Elements (432) in einer Richtung im Wesentlichen orthogonal zu der Montagerichtung unterbunden ist,
**dadurch gekennzeichnet, dass** eine Mehrzahl von Vorsprüngen (701, 702, 801, 802), die durch das vorstehende Element (432) plastisch verformt werden, an dem starren Passelement (431) in einer Mehrzahl von Richtungen im Wesentlichen orthogonal zu der Montagerichtung angeordnet sind.

2. Montagestruktur nach Anspruch 1,
**dadurch gekennzeichnet, dass** in einem Zustand, in dem die montierte Komponente (110) mittels der Montagekomponente (120) montiert ist, der zweite Anlagebereich (302) an einer Position, die einer Position entspricht, an der eine gekrümmte Fläche gebildet ist, an einer Außenumfangsfläche angeordnet ist, die durch die montierte Komponente (110) und die Montagekomponente (120) gebildet ist.

3. Montagestruktur nach Anspruch 1 oder 2,
**dadurch gekennzeichnet, dass** der erste Anlagebereich (301) derart angeordnet ist, dass er zwischen zwei zweiten Anlagebereichen (302) an einer Position, die einer Position entspricht, an der eine ebene Fläche gebildet ist, an der Außenumfangsfläche angeordnet ist.

4. Montagestruktur nach Anspruch 3,
**dadurch gekennzeichnet, dass** Vorsprünge (702), die durch vorstehende Elemente (432) plastisch verformt werden, an starren Passelementen (431) des zweiten Anlagebereichs (302) in einer Richtung im Wesentlichen orthogonal zu der ebenen Fläche einander zugewandt gegenüberliegend angeordnet sind.

5. Montagestruktur nach einem der Ansprüche 1 bis 3,
**dadurch gekennzeichnet, dass**
an dem ersten Anlagebereich (301) das Hakenelement (422) an der Montagekomponente (120) angeordnet ist und das Verriegelungselement (421) an der montierten Komponente (110) angeordnet ist (301), und
an dem zweiten Anlagebereich (302) das vorstehende Element (432) an der Montagekomponente (120) angeordnet ist und das starre Passelement (431) an der montierten Komponente (110) angeordnet ist.

## Revendications

1. Structure de montage qui présente un composant d'assemblage (120) et un composant assemblé (110) qui est assemblé au composant d'assemblage (120), la structure de montage comprenant :
une première portion faisant office de butée (301) et une deuxième portion faisant office de butée (302) dans lesquelles le composant d'assemblage (120) et le composant assemblé (110) viennent buter l'un contre l'autre lorsque le composant assemblé (110) est assemblé par le composant d'assemblage (120) ;
dans laquelle la première portion faisant office de butée (301) présente :
(i) un élément en forme de crochet (422) qui s'étend dans la direction d'assemblage ; et
(ii) un élément de verrouillage (421) qui verrouille l'élément en forme de crochet (422) dans le but de l'empêcher de se déplacer dans la direction d'assemblage dans un état dans lequel le composant assemblé (110) est assemblé au composant d'assemblage (120) ; et
dans laquelle la deuxième portion faisant office de butée (302) présente :
(i) un élément faisant saillie (432) qui s'étend dans la direction d'assemblage ; et
(ii) un élément de fixation rigide (431) qui fixe de manière rigide l'élément faisant saillie (432) par le fait que l'élément de fixation rigide (431 est soumis à une déformation plastique par l'intermédiaire de l'élément faisant saillie (432) lorsque le composant assemblé (110) est assemblé au composant d'assemblage (120), pour de cette manière restreindre le mouvement de l'élément faisant saillie (432) dans une direction qui est essentiellement orthogonale par rapport à la direction d'assemblage ;
**caractérisée en ce que**
un certain nombre de protrusions (701, 702, 801, 802), qui sont soumises à une déformation plastique par l'intermédiaire de l'élément faisant saillie (432), sont disposées sur l'élément de fixation rigide (431) dans un certain nombre de directions qui sont essentiellement orthogonales par rapport à la direction d'assemblage.

2. Structure de montage selon la revendication 1, **caractérisée en ce que** la deuxième portion faisant office de butée (302) est disposée à un endroit qui correspond à un endroit où se trouve une surface courbe, sur une surface circonférentielle externe formée par le composant assemblé (110) et par le composant d'assemblage (120) dans un état dans lequel le composant assemblé (110) est assemblé par l'intermédiaire du composant d'assemblage (120).

3. Structure de montage selon la revendication 1 ou 2, **caractérisée en ce que** la première portion faisant office de butée (301) est conçue pour venir s'intercaler entre deux deuxièmes portions de butée (302) à un endroit qui correspond à un endroit où se trouve une surface plate, sur la surface circonférentielle externe.

4. Structure de montage selon la revendication 3, **caractérisée en ce que** des protrusions (702), qui sont soumises à une déformation plastique par l'intermédiaire d'éléments faisant saillie (432), sont disposées sur des éléments de fixation rigide (431) de la deuxième portion faisant office de butée (302) dans une direction essentiellement orthogonale par rapport à la surface plate, de façon à se faire mutuellement face.

5. Structure de montage selon l'une quelconque des revendications 1 à 3, **caractérisée en ce que**
l'élément en forme de crochet (422) est disposé sur le composant d'assemblage (120) et l'élément de verrouillage (421) est disposé sur le composant assemblé (110) à la première portion faisant office de butée (301) ; et
l'élément faisant saillie (432) est disposé sur le composant d'assemblage (120) et l'élément de fixation rigide (431) est disposé sur le composant assemblé (110) à la deuxième portion faisant office de butée (302).
